# EUROPEAN PATENT SPECIFICATION

(11) **EP 2 433 320 B1**
(45) Date of publication and mention of the grant of the patent: **22.04.2020**
(21) Application number: 10726036.6
(22) Date of filing: 04.06.2010
(51) Int. Cl.: H01L 51/56

(54) **Method of manufacturing electronic devices**
Herstellungsverfahren für elektronische Vorrichtungen
Méthode de fabrication de dispositifs électroniques

(30) Priority: 05.06.2009 GB 0909721
(43) Date of publication of application: 28.03.2012
(73) Proprietor: Flexenable Limited, Milton Road Cambridge Cambridgeshire CB4 0FX (GB)
(72) Inventor: JOIMEL, Jerome, Cambridge CB4 OFX (GB); RAMSDALE, Catherine, Cambridge CB4 OFX (GB); PLACIDO, Frank, Paisley PA1 2BE (GB)
(74) Representative: Style, Kelda Camilla Karen
(86) International application number: PCT/EP2010/057863
(87) International publication number: WO 2010/139802

(56) References cited:
- EP-A1- 1 734 794
- EP-A1- 1 760 798
- US-A1- 2002 043 929
- US-A1- 2003 184 219
- US-A1- 2005 029 514
- US-A1- 2005 156 163
- US-A1- 2006 216 909
- US-A1- 2007 221 958
- Xue-Jian Liu ET AL: "Growth and properties of silicon nitride films prepared by low pressure chemical vapor deposition using trichlorosilane and ammonia", Thin Solid Films, vol. 460, no. 1-2, 6 May 2004 (2004-05-06) , pages 72-77, XP055562121, AMSTERDAM, NL ISSN: 0040-6090, DOI: 10.1016/j.tsf.2004.01.104

## Description

The present invention relates to a method of manufacturing electronic devices, particularly devices including one or more organic layers as electronically-functional layers and/or as supporting layers.

The production of reliable electronic devices including such organic layers can be challenging for at least the following reasons.

Where a set of electronic elements are supported on a plastic substrate via an overlying organic planarisation layer, it has been found that the electronic elements and/or the interfaces between the electronic elements of such a device tend to suffer from degradation caused by contaminants such as moisture and/or oxygen.

Also, in an organic electronic device, the conductive elements are often provided as a patterned inorganic metal layer(s), and there can be the problem of ensuring sufficient adhesion between an inorganic metal layer and an underlying organic layer, such as an organic planarisation layer. It is an aim of the present invention to provide one or more techniques aimed at producing more reliable electronic devices.

US2005/0156163 describes the use of a silicon oxide subbing layer between a substrate and an aluminium electrode. EP1760798 describes the use of an inorganic insulating layer between a conductive element and a substrate. US2007/0221958 describes the use of a silicon oxide layer between a chromium layer and a PEN substrate. EP1734794 describes the use of a passivation film between a gate electrode and a substrate. US2005/0029514 describes the use of a silicon nitride layer between a gate electrode and a substrate.

The present invention provides a method according to claim 1.

In one embodiment, the supporting substrate comprises a planarising layer overlying the plastic base.

In one embodiment, said non-conducting layer is formed directly on said planarising layer.

In one embodiment, said bottom conductive layer defines the source-drain electrode pairs of an array of transistors.

In one embodiment, said bottom conductive layer defines the gate lines of an array of transistors.

In one embodiment, the method further comprises: securing said device substrate to a carrier using one or more adhesive layers; and forming said one or more electronic elements on the device substrate with the device substrate thus secured to the carrier; and wherein the nitride layer serves as the primary protection for the overlying electronic elements against the ingress of moisture and oxygen from the adhesive layers via the device substrate.

In one embodiment, the nitride layer has a smaller water vapour transmission rate than any layer between the carrier and the device substrate.

In one embodiment, the nitride layer has a water vapour transmission rate of less than 1g/m²/24 hours.

In one embodiment, the device substrate is formed directly on an adhesive unit that secures the device substrate to the carrier.

In one embodiment, the adhesive unit comprises adhesive layers on opposite sides of a support layer.

In one embodiment, a planarisation layer is provided between the device substrate and the electronic elements.

In one embodiment, the method further comprises not providing between the device substrate and carrier any layer whose sole function is to block the ingress of moisture and oxygen into the device substrate.

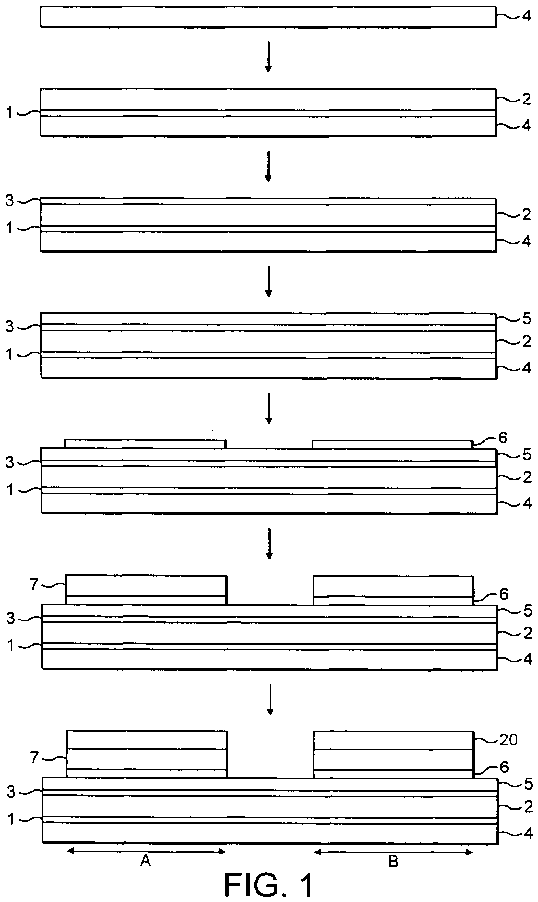

An embodiment of the present invention Is described In detail hereunder, by way of example only, with reference to the accompanying drawings, In which:-
Figure 1 Illustrates the production of a plurality of display devices In accordance with an embodiment of the present invention.

Figure 1 illustrates the production on a common carrier of two display devices including TFT arrays as back-planes, according to an embodiment of the present invention.

However, the technique described below and illustrated in Figure 1 is also applicable to the production of larger numbers of display devices on a common carrier.

A sheet of device substrate material 2 is temporarily secured to a glass carrier 4 (also referred to as a "mother plate") via a respective adhesive element 1, such as an adhesive element including one or more acrylic adhesive layers. The sheet of device substrate material 2 provides a plurality of device substrates, which are later cut from the device substrate material sheet 2 after the completion of the processing of the device substrates in situ on the carrier 4. The carrier 4 does not form part of the product devices, and the adhesive element 1 includes one or more layers made of an adhesive whose tackiness can be reduced by the action of heat or UV irradiation to allow the device substrates to be released from the carrier 4 at a later stage of the production process.

The device substrate material sheet 2 is a film of polyethyleneterephtalate (PET). Another example of a plastic substrate for this kind of device is a film of polyethylenenaphtalene (PEN).

A layer of planarising material 3 is deposited over the device substrate material sheet 2. The planarising material may be any material that provides a uniform, smooth surface on which to fabricate the transistor elements. For example, the planarising layer could be composed of a UV-cured acrylic coating or a thermal cured nanosilica/polysiloxane coating. Other examples of suitable organic planarising materials are cyanoacrylates, epoxies, fluoropolymers, plasticsol and acrylates. The planarising layer 3 may be deposited using techniques, such as, blade coating, screen printing, flexographic printing, spray coating, ink-jet printing or spin-coating or slit-coating.

Aluminium nitride is then deposited by sputter coating over the planarization layer 3 in the form of a continuous film 5. Deposition by sputter coating provides a film of aluminium nitride that conforms to the underlying planarisation layer, and therefore provides an equally planar surface suitable for the deposition of subsequent elements.

A patterned lower layer 6 of gold metal is then provided directly on the nitride layer 5 in each of the device regions A and B to provide the source-drain electrode pairs and signal lines of the array of transistors. The patterned gold layer 7 is formed by sputtering respective continuous layers of gold over the nitride layer 5 in the device regions A and B, and then patterning the continuous gold layers by an optical lithography technique or laser ablation technique. The gap between each source -drain electrode pair defines the width of the semiconductor channel of the respective transistor.

Examples of alternative materials for the lower conductive layer that provides the source- drain electrode pairs 6 etc. in this kind of device are materials that have a resistivity of lower than about 5 ohm/square, and a high work function of at least about 5 electron volts. Alternatively, a bi-layer of two metallic materials can be used in order to achieve both a high conductivity and a high work function. Examples of combinations of conductive materials are: silver (Ag) and copper (Cu); and nickel oxide (NiO) and palladium (Pd).

The next step involves forming the remaining elements of the display back plane. The collection of the remaining elements is designated in Figure 1 by reference numeral 7. The remaining elements include semiconductor channels between the source-drain electrode pairs, gate dielectric elements separating each semiconductor channel from the gate electrode of the same transistor, gate lines which provide the gate electrodes and means for addressing each transistor; and other elements such as pixel electrodes conductively connected to respective drain electrodes. Once, the display back plane is completed, the front plane 20 comprising the display medium is laminated to the backplane.

The semiconductor channels are provided by a layer of poly(9,9 '-dioctylfluorene-co-bis-N,N ')-(4-butylphenyl)diphenylamine (TFB), which is deposited by flexographic printing in each device regions A and B on top of the patterned metallic layer 6 as a semiconductor layer covering the source-drain electrode pairs and the gaps they define therebetween. The solution concentration and deposition conditions are chosen so as to produce a dry solid film of semiconductor of a thickness preferably in the region of about 50 nm.

Other examples of suitable semiconductor materials are: other polyfluorenes, such as poly(dioctylfluorene-co-bithiophene) (F8T2); polythiophenes, pentacene or pentacene derivatives (such as Triisopropylsilylethynyl (TIPS) pentacene). Other examples of coating techniques for forming the semiconductor layer are spin-coating, dip coating, blade coating, bar coating slot-die coating, or spray coating, inkjet, gravure, offset or screen printing, sputter coating and vapour deposition.

For the gate dielectric elements, one or more layers of gate dielectric material 10 is then deposited by flexographic printing in device regions A and B onto the underlying active semiconductor layer. The materials and solvents for the deposition of these semiconductor and gate dielectric layers are carefully selected in accordance with the technique described in WO01/47043 with the aim of minimising degradation of the semiconductor layer by the process of depositing the gate dielectric layer.

Other examples of coating techniques for forming the gate dielectric layer are spin-coating, dip coating, blade coating, bar coating slot-die coating, or spray coating, inkjet, gravure, offset or screen printing, sputter coating and vapour deposition.

Other examples of suitable solution-processible gate dielectric materials that may be used are: polymethylmethacrylate (PMMA), which is solublein e.g. ethylacetate; Cytop®, which is an amorphous fluoropolymer available from AGC Chemicals Europe, Ltd, and which is soluble in e.g. a perfluoro solvent such as perfluorotributylamine (FC43); and polyisobutylene (PIB). Each gate dielectric element may have a multilayer construction, comprising a stack of two or more layers of different dielectric materials between the semiconducting layer and the gate electrode.

The gate lines are provided by the sputter-deposition and patterning of an upper gold layer. The patterning is carried out by photolithography or laser ablation. Examples of other suitable materials for a gate electrode include other highly conductive metals, such as copper (Cu), a solution-processible material containing inorganic nanoparticles of silver or other metals, and a conducting polymer such as PEDOT/PSS. The conductive layer for forming the gate lines can be deposited using other vapour-deposition techniques such as evaporation. Alternatively, the conductive layer for forming the gate lines can be deposited by coating a solution-processible conductive material (or precursor thereto) onto the underlying gate dielectric layer(s). Examples of suitable coating techniques include spin, dip, blade, bar, slot-die, gravure, offset or screen or inkjet printing.

The insulating nitride layer 5 serves two functions: (i) to improve the adhesion between the planarising layer 3 and the lower gold layer 6; and (ii) to serve as a barrier protecting the overlying electronic elements (and any other overlying sensitive elements) from the ingress of moisture and oxygen via the plastic substrate.

For (i), the level of adhesion between the insulating nitride layer 5 and the gold metal layer 7 is found to be sufficiently high to make it unnecessary to use an intermediate metal layer as an adhesion promoter layer directly under the gold layer 7. The increase in adhesion provided by the insulating nitride layer can be confirmed by the ASTM D3359-09 Standard test method for measuring the adhesion of the metal on the substrate by the use of a tape test. In more detail, a blade is used to cut parallel lines into the subject layer of the test, (i.e. the metal layer whose adhesion to an underlying substrate is to be measured) to create a grid pattern of cut lines. An adhesive tape is placed over the grid and smoothed out to make good contact with the grid-patterned subject layer. The adhesive tape is then pulled back using the free end to a 180 degree angle, and the thus exposed grid-patterned subject layer is inspected for adhesion failure. By means of this test, it was demonstrated that the insulating nitride layer 5 improves the adhesion of the lower metal layer 6 to the underlying planarisation layer 3. Good adhesion is characterised by no detachment of the subject layer in the grid squares.

The inventors have found that the purity level of the nitride at the surface of the nitride layer on which the gold is deposited can affect the adhesion promoting performance of the nitride layer. In the invention, steps are taken to reduce the atomic percentage of oxygen at the surface of the nitride layer. Firstly, sputtering of the nitride layer is carried out after pumping down the sputtering chamber to a base pressure of lower than about 1E-4Pa, and leaving the substrate at such low pressure for a length of time. This reduces the oxygen level present in the sputtering chamber, and also reduces the amount of oxygen present in the plastic substrate in the form of moisture. Baking the substrate at said low pressure will further assist the outgasing of the plastic substrate and the reduction of the amount of oxygen in the sputtering chamber. Also, after sputter-deposition of the nitride layer 5, the nitride layer is subjected to a plasma treatment, such as an argon (Ar) or nitrogen (N₂) plasma treatment. The inventors have found that a good degree of adhesion between the gold layer and the nitride layer can be achieved with an atomic purity of more than 90% (i.e. a nitride surface that includes less than 10 atomic percent oxygen).

For (ii), it is thought that one significant route for contaminants such as moisture and oxygen to reach the electronic elements in this kind of production process is via the adhesive layer (s) of adhesive element 1 and the device substrate material sheet 2, including the interface between an adhesive layer and the device substrate material sheet 2. In particular, it is thought that the adhesive layer(s) provide a route for the ingress of such contaminants via their interface with other layers, such as the overlying device substrate material sheet 2 in Figure 1. The nitride layer 5 provides a barrier against the ingress of such species. The nitride layer 5 is configured to provide a water vapour transmission rate (WVTR) of no more than about 1 to 10⁻⁷ g/m²/day (e.g. 0.5g/m²/day), as measured under the following conditions: atmospheric pressure; 100% relative humidity; and a temperature of 38°C. A water vapour permeation instrument provided by Mocon, Inc. can be used to measure the water vapour transmission rate.

The nitride layer 5 exhibits a lower WVTR than any other layer between the bottom conductive layer 6 and the bottom surface of the adhesive element 1, and thus provides the main protection for the electronic elements against the ingress of moisture and oxygen via any of the adhesive layers that constitute the adhesive element 1.

Where the device substrate material sheet Itself serves as a barrier against the transmission of moisture and oxygen (such as can be the case, where inorganic glass is used for the device substrate material sheet, such cases not forming part of the invention), intermediate layer 5 need only serve the function of improving the adhesion between the lower metal layer 6 and the underlying planarisation layer 3.

Examples of other materials for intermediate layer 5 are other inorganic nitrides that are electrically Insulating, particularly those that are suitable for deposition by sputter coating or other vapour deposition techniques.

One advantage of the use of an insulating material for intermediate layer 5 is that there Is no need to pattern Intermediate layer 5 to avoid shorts between elements of the overlying lower metal layer 6, which is advantageous from the point of view of reducing the number of process steps, and reducing the risk of bowing and/or other distortion of the multilayer stack during processing. A resistivity of at least 5E12 Ohms/sq for the Intermediate layer 5 was found to be sufficient to prevent significant leakage current between source and drain electrodes via the intermediate layer 5. Moreover, not having to pattern intermediate layer 5 by a photolithographic technique Involving the use of a solvent/etchant has the advantage of better avoiding the risk of a build up of solvent residue underneath the lower metal layer 6. The existence of solvent residue is generally undesirable because it can diffuse through the device affecting the overall performance and stability of the device.

In order to further protect against the ingress of moisture and oxygen into the electronic elements via the device substrate, one variation involves adding a further barrier layer between one or more of the adhesive layer(s) of adhesive element 1 and the device substrate material sheet 2, but no such additional barrier layer is included in the example of Figure 1. The nitride layer 5 provides the primary protection for the TFT array against the ingress of oxygen and moisture via the device substrate material sheet 2.

The technique described above is also applicable to alternative device configurations, such as a bottom-gate TFT configuration, in which the lower metal layer 6 instead defines the gate lines,, and the upper metal layer 6 instead defines the source-drain electrode pairs and interconnect/signal lines of the array of transistors.

We have chosen the example of a display backplane comprising an active matrix array of TFTs for the purpose of describing an embodiment of the invention. However, the techniques described above also have application in other arrangements of TFTs with or without other components such as interconnects, resistors, and capacitors. Examples of other applications include logic circuits, active matrix circuitry for a memory device, and a user-defined gate array circuit. The above-described techniques are also applicable to other kinds of electronic devices such as light-emitting diodes (LED) or photovoltaic devices.

Also, for the above description of techniques in accordance with embodiments of the present invention, we have chosen the example of using the nitride layer 5 to provide primary protection against the ingress of degrading species from adhesive layers used to secure a device substrate to a planar carrier. However, the same kind of techniques are also applicable to preventing the ingress of degrading species when a device substrate Is mounted on other processing tools such as a support roller in a roll-to-roll technique.

Also, for the above description of techniques in accordance with embodiments of the present invention, we have chosen the example of forming a plurality of TFT arrays on a sheet of device substrate material and then later dividing the sheet of substrate material into Individual device substrates. However, the same kind of techniques are also applicable to the case where one or more device substrates are secured individually to carrier before forming one or more electronic elements on the device one or more device substrates.

In view of the foregoing description it will be evident to a person skilled in the art that various modifications may be made within the scope of the invention.

## Claims

1. A method, comprising: forming on a support substrate (2) comprising a plastic base a plurality of electronically functional elements defined by a stack of layers (6, 7) including a bottom conductive layer (6), wherein the method comprises the step of forming between the support substrate and the bottom conductive layer a non-conducting layer (5) that functions to increase the adhesion of said bottom conductive layer to the support substrate, wherein the non-conducting layer comprises a nitride layer, and **characterised in that** the nitride layer is formed by sputtering, and the method comprises, prior to forming said nitride layer, subjecting the support substrate to baking in the sputtering chamber at a pressure of lower than 1E-4 Pa.

2. A method according to claim 1, wherein the support substrate comprises a a planarising layer overlying the plastic base.

3. A method according to claim 2, comprising forming said non-conducting layer directly on said planarising layer.

4. A method according to any of claims 1 to 3, wherein said bottom conductive layer defines the source-drain electrode pairs of an array of transistors.

5. A method according to any of claims 1 to 3, wherein said bottom conductive layer defines the gate lines of an array of transistors.

6. A method according to any preceding claim, further comprising subjecting the nitride layer to a plasma treatment.

## Patentansprüche

1. Verfahren, umfassend: Bilden von mehreren elektronischen Funktionselementen, die durch einen Stapel von Schichten (6, 7) definiert sind, die eine untere leitfähige Schicht (6) beinhalten, auf einem Trägersubstrat (2), das eine Kunststoffbasis umfasst, wobei das Verfahren den Schritt eines Bildens einer nichtleitfähigen Schicht (5), die dazu fungiert, die Adhäsion der unteren leitfähigen Schicht an dem Trägersubstrat zu erhöhen, zwischen dem Trägersubstrat und der unteren leitfähigen Schicht umfasst, wobei die nichtleitfähige Schicht eine Nitridschicht umfasst, und **dadurch gekennzeichnet, dass** die Nitridschicht durch Sputtern gebildet wird und das Verfahren vor dem Bilden der Nitridschicht ein Unterziehen des Trägersubstrats einem Brennen in der Sputterkammer bei einem Druck von weniger als 1E-4 Pa umfasst.

2. Verfahren nach Anspruch 1, wobei das Trägersubstrat eine planarisierende Schicht umfasst, die auf der Kunststoffbasis aufliegt.

3. Verfahren nach Anspruch 2, umfassend ein Bilden der nichtleitfähigen Schicht direkt auf der planarisierenden Schicht.

4. Verfahren nach einem der Ansprüche 1 bis 3, wobei die untere leitfähige Schicht die Source-Drain-Elektrodenpaare eines Arrays von Transistoren definiert.

5. Verfahren nach einem der Ansprüche 1 bis 3, wobei die untere leitfähige Schicht die Gate-Leitungen eines Arrays von Transistoren definiert.

6. Verfahren nach einem vorhergehenden Anspruch, weiterhin umfassend ein Unterziehen der Nitridschicht einer Plasmabehandlung.

## Revendications

1. Procédé, comportant: l'étape consistant à former, sur un substrat de support (2) comportant une base en plastique, une pluralité d'éléments électriquement fonctionnels définis par un empilement de couches (6, 7) comprenant une couche conductrice inférieure (6), dans lequel le procédé comporte l'étape consistant à former entre le substrat de support et la couche conductrice inférieure une couche non conductrice (5) qui a pour fonction d'augmenter l'adhérence de ladite couche conductrice inférieure par rapport au substrat de support, dans lequel la couche non conductrice comporte une couche de nitrure, et **caractérisé en ce que** la couche de nitrure est formée par pulvérisation, et le procédé comporte, avant l'étape consistant à former ladite couche de nitrure, l'étape consistant à soumettre le substrat de support à une opération d'étuvage dans la chambre de pulvérisation à une pression de moins de 1E-4 Pa.

2. Procédé selon la revendication 1, dans lequel le substrat de support comporte une couche de planarisation recouvrant la base en plastique.

3. Procédé selon la revendication 2, comportant l'étape consistant à former ladite couche non conductrice directement sur ladite couche de planarisation.

4. Procédé selon l'une quelconque des revendications 1 à 3, dans lequel ladite couche conductrice inférieure définit les paires d'électrodes source-déversoir d'un réseau de transistors.

5. Procédé selon l'une quelconque des revendications 1 à 3, dans lequel ladite couche conductrice inférieure définit les lignes de grille d'un réseau de transistors.

6. Procédé selon l'une quelconque des revendications précédentes, comportant par ailleurs l'étape consistant à soumettre la couche de nitrure à un traitement par plasma.
